# EUROPEAN PATENT APPLICATION

(11) **EP 1 788 677 A1**
(43) Date of publication of application: **23.05.2007**
(21) Application number: 06023379.8
(22) Date of filing: 09.11.2006
(51) Int. Cl.: H01S 5/40, H01S 5/022, H01S 5/024, G02B 27/09

(54) **Stack of vertically displaced multi-mode single emitter laser diodes**

(30) Priority: 22.11.2005 US 739185 P; 20.12.2005 US 313068; 17.03.2006 US 378570; 17.03.2006 US 378667; 17.03.2006 US 378696; 17.03.2006 US 378697; 20.03.2006 US 384940; 04.05.2006 US 417581; 24.07.2006 US 492140; 08.09.2006 US 517628
(71) Applicant: nLight Photonics Corporation, Vancouver WA 98665 (US)
(72) Inventor: Farmer, Jason Nathaniel, Vancouver WA 98663 (US); Schulte, Derek E., Portland OR 97210 (US); Yan, Yu, Vancouver WA 98683 (US)
(74) Representative: Eisenführ, Speiser & Partner

(57) **Abstract**

An optical source comprised of a stack of at least two laser diode subassemblies (1203-1207) is provided. Each laser diode subassembly includes a submount (601) and a multimode, single emitter laser diode (603). Each of the at least two laser diode subassemblies is mounted to a mounting member (1209). Means are included to vertically displace the output beams from the individual laser diode subassemblies to form an optical source output beam. In at least one embodiment, the mounting member (1209) performs the function of the vertically displacing means.

## Description

### FIELD OF THE INVENTION

The present invention relates generally to semiconductor lasers and, more particularly, to an ultra high brightness solid state laser assembly.

### BACKGROUND OF THE INVENTION

Laser diodes offer both high output power and a small footprint, making them ideal candidates for a variety of applications including materials processing, medical devices, telecommunications, printing/imaging systems and the defense industry. In most applications the output of the laser diode is injected into an optical fiber, the fiber either being integral to another laser, i.e., a fiber laser, or simply a conduit for carrying the output of the laser diode. In the case of a fiber laser, the output from the laser diode is coupled into the cladding of the fiber, from which it is transferred into the core and pumps the dopant contained within the fiber's core.

Typically the selection of a particular laser diode for a specific application is based on output power, wavelength and brightness, brightness being measured in units of power per area times the angular divergence (i.e., watts/(mm-mrad)²). Since the output beam of a laser diode is asymmetric due to the beam having a lower beam parameter product (i.e., the product of the beam size width and the angular divergence) in the direction perpendicular to the diode junction (i.e., the fast axis of the emitter) than in the direction parallel to the diode junction (i.e., the slow axis of the emitter), the brightness of a laser diode is different in the fast and slow axes.

Laser diode bars, a specific type of laser diode, offer significant power levels and are therefore commonly used in most high power applications. This type of laser diode is approximately I centimeter in width and comprised of between 10 and 80 emitters. Although the aperture of the individual emitters is typically 1 micron (vertical) by 50-300 microns (lateral), the total aperture of the laser bar is approximately 2 microns by 0.3-0.9 centimeters. The large aperture combined with the inherent divergence of the individual emitters leads to an exceptionally large beam parameter product in the lateral dimension making this type of laser diode difficult to couple into an optical fiber. Accordingly, a variety of techniques have been devised to improve the coupling efficiency between the laser bar and the optical fiber, these techniques generally employing beam-shaping optics to reformat the output of the laser bar. These reformatting systems reduce the beam parameter product in the lateral dimension by increasing the beam parameter product in the vertical dimension. One such reformatting system is disclosed in U.S. Patent No. 5,168,401. The disclosed system uses reflective elements, typically at least two reflective elements, to individually rotate each output beam prior to reimaging by symmetric and asymmetric optics, the asymmetric optics preferentially imaging one dimension while leaving the focus in the second dimension largely unaffected.

U.S. Patent No. 6,700,709 discloses an alternate reformatting system using a beam inversion optic based on arrays of graded index optics, cylindrical Fresnel lenses, reflective focusing optics or a general optical system. The beam shaping optics have a magnification equal to -1, the intent being to maximize the output brightness of the laser bar. The patent discloses that prior to the beam inversion optic, the fast axis of the individual emitters of the diode array can be collimated with a single cylindrical lens. Additionally the slow axis of the individual emitters can also be collimated.

Although the prior art discloses techniques for reformatting the output of a laser diode bar so that it can be more efficiently coupled into an optical fiber or similar optical component, a high brightness laser source that can be more efficiently coupled into such a fiber or component is desired. The present invention provides such a laser diode source.

### SUMMARY OF THE INVENTION

The present invention provides an optical source comprised of a stack of at least two laser diode subassemblies, alternately at least three laser diode subassemblies, or alternately at least four laser diode subassemblies. Each laser diode subassembly includes a submount to which a multi-mode, single emitter laser diode is attached. Each of the at least two laser diode subassemblies is mounted to a mounting member. Means are included to vertically displace the output beams from the individual laser diode subassemblies to form an optical source output beam. In at least one embodiment of the invention, the mounting member performs the function of the vertically displacing means.

In at least one embodiment of the invention, an optical source comprised of a stack of a plurality of laser diode subassemblies is provided. Each laser diode subassembly includes a submount to which a multi-mode, single emitter laser diode is attached. Each of the laser diode subassemblies is mounted to a mounting member. Means are included to vertically displace the output beams from the individual laser diode subassemblies. In at least one embodiment, each of the multi-mode, single emitter laser diodes has an emitter width in the range of 20 to 50 microns and the plurality of laser diode subassemblies is comprised of 2 to 5 laser diode subassemblies. In at least one other embodiment, each of the multi-mode, single emitter laser diodes has an emitter width in the range of 50 to 150 microns and the plurality of laser diode subassemblies is comprised of 2 to 20 laser diode subassemblies. In at least one other embodiment, each of the multi-mode, single emitter laser diodes has an emitter width in the range of 100 to 250 microns and the plurality of laser diode subassemblies is comprised of 2 to 30 laser diode subassemblies. In at least one other embodiment, each of the multi-mode, single emitter laser diodes has an emitter width in the range of 200 to 400 microns and the plurality of laser diode subassemblies is comprised of 2 to 50 laser diode subassemblies. In at least one other embodiment, each of the multi-mode, single emitter laser diodes has an emitter width in the range of 300 to 600 microns and the plurality of laser diode subassemblies is comprised of 2 to 80 laser diode subassemblies. In at least one other embodiment, each of the multi-mode, single emitter laser diodes has an emitter width in the range of 600 to 1200 microns and the plurality of laser diode subassemblies is comprised of 2 to 150 laser diode subassemblies.

A further understanding of the nature and advantages of the present invention may be realized by reference to the remaining portions of the specification and the drawings.

### BRIEF DESCRIPTION OF THE DRAWINGS

Fig. 1 is an illustration of the end view of a typical laser bar according to the prior art;
Fig. 2 graphically compares the éntendue for a 100 micron optical fiber with that of a laser bar;
Fig. 3 graphically compares the éntendue for a 100 micron optical fiber with that of a single 200 micron wide emitter;
Fig. 4 graphically compares the éntendue for a 50 micron optical fiber with that of a single 114 micron wide emitter;
Fig. 5 graphically compares the éntendue for a 50 micron optical fiber with that of a stack of twelve 80 micron wide emitters;
Fig. 6 is a perspective view of a laser diode subassembly minus the second conditioning lens;
Fig. 7 is a perspective view of the laser diode subassembly of Fig. 6, including a second conditioning lens associated with another (not shown) laser diode subassembly;
Fig. 8 is an illustration of a stepped cooling block with recessed laser diode subassembly mounting surfaces;
Fig. 9 is an illustration of an alternate stepped cooling block with raised laser diode subassembly mounting surfaces;
Fig. 10 is an illustration of an alternate stepped cooling block with adjacent mounting surfaces;
Fig. 11 is an illustration of an alternate stepped cooling block with coplanar mounting surfaces;
Fig. 12 is an illustration of a cooling block in which multiple laser diode subassemblies are clamped in place;
Fig. 13 is a perspective view of an alternate laser diode subassembly;
Fig. 14 is a perspective view of an alternate laser diode subassembly;
Fig. 15 is a perspective view of an alternate laser diode subassembly;
Fig. 16 is a perspective view of a laser diode stack comprised of six laser diode subassemblies similar to the subassembly shown in Fig. 13;
Fig. 17 is a perspective view of a laser diode stack comprised of six laser diode subassemblies similar to the subassembly shown in Fig. 15; and
Fig. 18 is a perspective view of the laser diode stack of Fig. 17 attached to a cooling block.

### DESCRIPTION OF THE SPECIFIC EMBODIMENTS

In a variety of applications ranging from fiber lasers to end pumped solid state lasers to those that utilize fiber delivery systems, performance is limited by the power of the source. Typically in such applications requiring high power, multiple laser diode bars or laser diode bar arrays are used which are capable of delivering hundreds to thousands of watts. The inventors of the present invention have found, however, that although the output power of such a device can be quite high, the beam characteristics of diode laser bars reduce their effectiveness in a variety of applications. As a result, the present invention utilizes a significantly different configuration, one that does not utilize laser bars.

In a common laser diode application, the output of the laser diode is coupled into a fiber. As described in detail below, due to the diameter and limited numerical aperture of most fibers, the power of a laser diode or a laser diode array that can be coupled into the fiber is determined not by the output power of the laser diode/array, but rather by the brightness of the laser diode/array, brightness being defined as the power emitted per surface area per solid angle. Accordingly, in order to characterize a source, the important characteristics are not only its power, but also the size of its aperture and the divergence of the output beam.

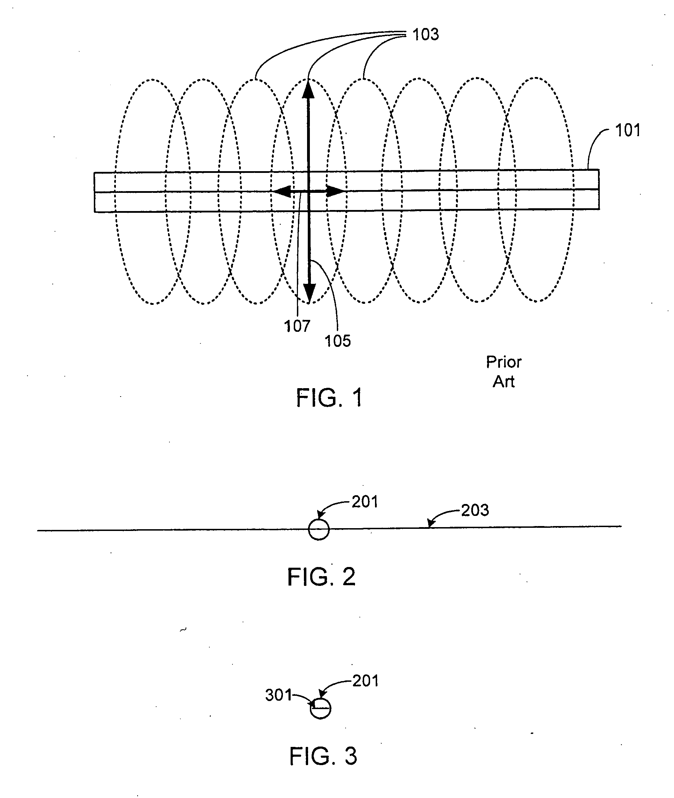

Fig. 1 shows the end view of a typical prior art laser bar 101. Such a laser bar is approximately 1 centimeter in width and comprised of between 10 and 80 emitters (note that only 8 beams 103 are shown in Fig. 1 for illustration clarity). An emitter is a semiconductor device that emits light spatially continuously over a certain lateral aperture. The lateral aperture of an individual multi-mode emitter is typically on the order of 0.05 to 0.3 millimeters while the lateral aperture of an individual single mode emitter is typically less than 0.005 millimeters. The total lateral aperture of a laser bar from which light is emitted is the sum of all the lateral apertures of each of the constituent emitters and is on the order of 3 to 9 millimeters. The vertical aperture of the bar, i.e., measured in the fast axis, is on the order of 2 to 5 microns since, as described in further detail below, the bar's vertical aperture is often much larger than the vertical aperture of the individual emitters due to the "smile" of the laser bar, a term that refers to the warping of the device during fabrication. The divergence of the output of each emitter is also asymmetric, each emitter emitting an elliptical beam 103 with the divergence in fast axis 105, perpendicular to the diode junction, being approximately 5 times the divergence along slow axis 107. Typically the divergence in the fast axis is in the range of 20° to 40° full width at half maximum (FWHM) (most commonly, 35°) while the divergence in the slow axis is in the range of 6° to 10° FWHM (most commonly, 10°).

Due to the large lateral aperture of a laser bar as previously noted, such a device exhibits extremely asymmetric brightness levels. As a result, and as illustrated in Table I and discussed further below, a laser bar is a very inefficient source for coupling into any component exhibiting a symmetric input aperture and input acceptance angle, for example a typical optical fiber. For comparison purposes, Table I also illustrates the performance of a 7 watt laser diode single emitter. In Table I, coupling efficiency and the amount of device output power that is coupled into a fiber assumes an optical fiber with a diameter of 0.1 millimeter and a numerical aperture (hereafter, NA) of 0.2. As illustrated in Table I, due to the large lateral aperture of the laser bar, less than 3 watts of the output power of the laser bar is coupled into the optical fiber. In contrast, all of the output power of the single emitter, i.e., 7 watts, is coupled into the same fiber.

As used herein, the slow axis beam parameter product (hereafter BPP_{SA}) is defined as the product of the lateral aperture and the slow axis divergence. Similarly, the fast axis beam parameter product (hereafter BPP_{FA}) is defined as the product of the vertical aperture and the fast axis divergence. The étendue, as used herein, is defined as the product of BPP_{SA} and BPP_{FA}. Accordingly, the BPP for both axes of the optical fiber referred to in the above illustration is 40 mm-mrad while the étendue of the fiber is 1600 (mm-mrad)².

**Table I**

| | Laser Bar | Single Emitter |
|---|---|---|
| Total Power Output (watts) | 100 | 7 |
| Lateral Aperture (mm) | 10 | 0.2 |
| Slow Axis Divergence (mrad) | 174.53 (10°) | 174.53 (10°) |
| Slow Axis Beam Parameter Product (mm-mrad) | 1745.3 | 34.9 |
| Slow Axis Brightness (watts/(mm-mrad)) | 0.057 | 0.201 |
| Theoretical Slow Axis Coupling Efficiency (%) | 2.3 | 100 |
| Vertical Aperture (mm) | 0.005 | 0.001 |
| Fast Axis Divergence (mrad) | 610.87 (35°) | 610.87 (35°) |
| Fast Axis Beam Parameter Product (mm-mrad) | 3.05 | 0.61 |
| Fast Axis Brightness (watts/(mm-mrad)) | 32.8 | 11.5 |
| Theoretical Fast Axis Coupling Efficiency (%) | 100 | 100 |
| Etendue (mm-mrad)² | 5,323.2 | 21.3 |
| Device Brightness (watts/(mm-mrad)²) | 0.019 | 0.329 |
| Power Coupled Into Fiber (watts) - No Beam Reformatting | 2.3 | 7 |
| Power Coupled Into Fiber (watts) - With Beam Reformatting | 30 | 7 (no reformatting req'd) |

Given the high output power of a laser bar, considerable effort has been expended to determine ways of reformatting the output into a format that can be more efficiently coupled into an optical fiber. One exemplary reformatting system is described in U.S. Patent Serial No. 6,044,096. In addition to being extremely complex, and thus costly, reformatting systems are limited by the overall brightness of the laser bar. In the example shown in Table I, the BPP_{SA} of the bar (i.e., 1745.3 mm-mrad) limits the fiber coupling efficiency to 2.3% since the BPP_{SA} of the fiber is 40 mm-mrad. Beam reformatting optics can be used to lower the bar's BPP_{SA} to improve the coupling efficiency; however, this improvement in BPP_{SA} is achieved by degrading the BPP_{FA} in such a way that the étendue remains constant. Therefore even if the shape of the above-described laser bar is reformatted to fit within the entrance aperture of the fiber used in the above example, the divergence of the beam will exceed the NA of the fiber and limit the amount of the laser bar's output power that can be coupled into the fiber to approximately 30 percent (i.e., 30 watts). Similarly, reformatting the output of the laser bar to reduce the divergence angle to less than that of the fiber's acceptance angle will result in the size of the output beam being too large to fit within the entrance aperture of the fiber, once again limiting the laser bar's output power coupled into the fiber to approximately 30 percent (i.e., 30 watts). In marked contrast, using this analysis it is theoretically possible to couple 75 individual single emitters into the same fiber. As a result, 525 watts or almost 20 times the output power can be coupled into the fiber by replacing the laser bar with an array of single emitters.

As described in detail above, a laser bar is a very inefficient source for coupling high power into any component with restrictive input apertures/acceptance angles (e.g., an optical fiber) regardless of whether or not the bar's output beam is reformatted. Additionally, laser bars suffer from a variety of other drawbacks that make them less desirable than the laser diode stacks described herein. Paramount among these drawbacks is heat dissipation.

In a laser bar the center-to-center spacing of the emitters is relatively small, thus providing the desired packing density of emitters within the bar. As a result, heat generated by the individual emitters does not have any space available for lateral heat spreading, thereby requiring all of the generated heat to be vertically dissipated through the bottom surface of the device. In contrast, single emitters can dissipate the generated heat both vertically and laterally. Similarly, in a high power device consisting of numerous individually packaged single emitters, there is minimal thermal cross talk, thus again allowing both vertical and lateral heat dissipation. As a result of the lower operating temperature achieved through more efficient vertical and lateral heat dissipation, devices based on individually packaged single emitters are also less likely to suffer from heat induced damage that those in a laser bar.

In addition to lowering the chances of heat induced damage, the improved heat dissipation achieved by single emitters allows such laser diodes to operate at full power. In contrast, the poor heat dissipation of a laser bar will often require it to operate at a lower power per emitter than desired (typically about one third the power level) in order to maintain the emitters at an acceptable temperature level.

One other advantage of the more efficient heat dissipation achieved by single emitters and multi-emitter arrays is that the heat dissipation requirements placed on the laser diode system are less demanding, thus allowing a smaller, more robust system to be designed and fabricated.

As previously noted, another issue that affects the performance of laser bars is smile, a term that refers to the warping of a laser diode bar that often occurs during device fabrication. Since smile causes the individual emitters of the laser bar to be at different heights, the primary effect is to increase the effective vertical aperture of the device, thereby decreasing the brightness of the bar. For example, assuming a modest smile, the effective vertical aperture of a laser bar can easily be doubled (e.g., from 1 micron to 2 microns). As a consequence of the vertical aperture being doubled, the brightness of such an exemplary laser bar would be halved. As those of skill in the art of laser diode fabrication will appreciate, smile does not affect single emitters. A secondary consequence of smile is its effects on heat dissipation. In particular, if a laser diode bar is warped, it may not contact the heat sink as well as it would if it were perfectly flat. This effect, in turn, can lead to increased emitter heating and the need to lower the output of the device to compensate for the lowered heat dissipation.

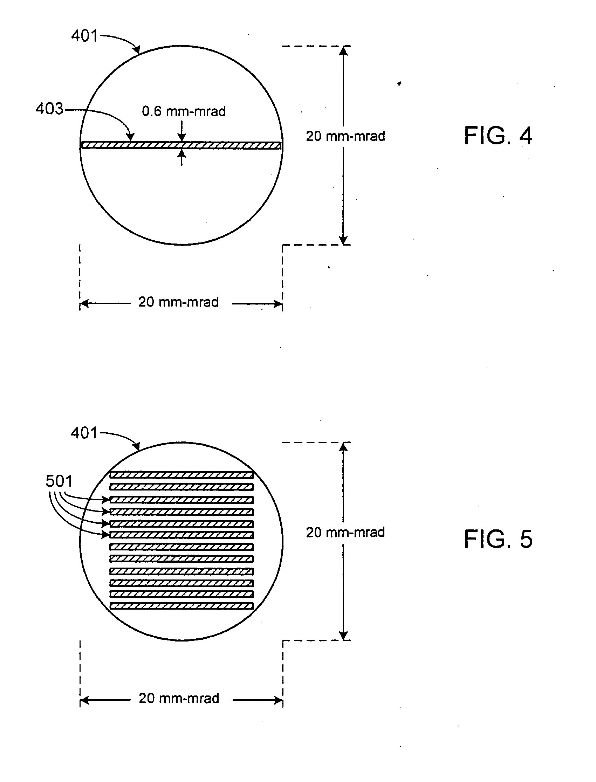

In light of the above-noted laser bar deficiencies as well as the advantages offered by single emitters, the present inventors have found that a stack consisting of at least two vertically displaced, multi-mode single emitters offers dramatic advantages over the performance provided by a laser bar. These advantages, described relative to Table I above, are illustrated in Figs. 2 and 3. In these figures circle 201 represents the éntendue for the above-described optical fiber, i.e., a fiber with a diameter of 100 microns and an NA of 0.2. Due to the fiber's symmetry, the BPP for both axes is 40 mm-mrad. Line 203 on Fig. 2 represents the éntendue of the laser bar of Table I while line 301 of Fig. 3 represents the éntendue of the single emitter of Table I, these two figures illustrating the inefficiency of coupling the output of a laser bar as compared to a single emitter to such an optical fiber. Figs. 4 and 5 utilize the same convention as that of Figs. 2 and 3 although the size of circle 401, representing the optical fiber's éntendue, has been increased to clarify the benefits of the invention. In Figs. 4 and 5 the optical fiber has a diameter of 50 microns, an NA of 0.2, and thus a BPP in each axis of 20 mm-mrad. Rectangle 403 represents the éntendue of a single 114 micron emitter. Due to the asymmetry in the emitter's brightness, very little of the BPP of the fiber is filled, as shown. By utilizing a stack of vertically displaced single emitters, each with a lateral aperture of 80 microns, the outputs of twelve emitters can be easily coupled into the same fiber. The éntendue of each 80 micron emitter is represented by a rectangle 501. Assuming an output power for the 114 micron emitter of 5 watts and an output power for each of the 80 micron emitters of 4 watts, the stack is able to couple almost 10 times the power into the same fiber. Note that the space shown between the emitters is provided to allow for fast axis collimating optics as well as other packaging constraints. Clearly the amount of space required for such optics and packaging varies, depending upon the exact implementation, accordingly it will be appreciated that the embodiment shown in Fig. 5 is only shown as an example of the improvements that can be achieved with the invention.

It will be appreciated there are almost limitless combinations of emitters that can be used in a vertically displaced stack depending not only upon emitter width and the number of emitters in the stack, but also on the desired stack output power and the éntendue of the device (e.g., fiber) into which the output of the stack is to be coupled. The inventors have determined, however, that certain combinations are more efficient from a manufacturing, and thus cost, point of view. In general, assuming a symmetrical input éntendue for the fiber (or other device) preferably the combined éntendue of the vertically displaced stack is also approximately symmetrical (for example, as shown in Fig. 5). Stack symmetry is not, however, a requirement of the invention as often the desired brightness can be achieved using a simpler, albeit less symmetrical, stack. For example, assuming a 150 micron optical fiber with an NA of 0.2 and an input power requirement of 10 watts, a stack of two 5 watt, 100 micron wide emitters will achieve the same performance as a stack of four 2.5 watt, 50 micron wide emitters while requiring fewer conditioning lenses and overall, less complex packaging.

Although the present invention is not limited to a specific laser diode stack, i.e., a stack with a set number of emitters with set emitter widths, the inventors have found that stack limitations can be made based on reasonable engineering criteria. In general the smaller the emitter width, the lower the upper limit on the number of emitters that constitute a reasonable stack. Additionally, the BPP_{SA} should be small enough, compared to the BPP_{SA} of the fiber (or device), to allow stacking while the BPP_{FA} of the total number of stacked emitters should be small enough, compared to the BPP_{FA} of the fiber (or device) to fit while providing space for lenses and packaging. For example, assuming an emitter width of 20 microns, a reasonable upper limit on an emitter stack is five emitters since the BPP_{SA} of such an emitter is approximately 3.49 mm-mrad (assuming a 10° slow axis divergence) while the BPP_{FA} of the stack is approximately 3.05 mm-mrad (assuming a 1 micron vertical aperture and a 35° fast axis divergence). Due to the symmetry of such a stack, it would efficiently fill a fiber or other device with a symmetrical éntendue, for example a 25 micron optical fiber with an NA of 0.1 and thus a BPP per axis of 5 mm-mrad.

In general, the lower limit for a stack in accordance with the present invention is 2 multi-mode emitters, regardless of emitter width. Although such a stack may not fill the intended fiber (or device) into which its output is to be coupled, it will be appreciated that in some instances the power of such a 2-emitter stack may be sufficient for the intended application. As previously noted, the upper limit for a stack is that which provides optimal symmetry, thus maximizing fiber (or device) fill efficiency. Although not a requirement of the invention, typically the stack size is selected such that the BPP_{FA} of the stack remains smaller than the BPP_{SA} of the individual emitters since after this point, i.e., once the BPP_{FA} of the stack exceeds the BPP_{SA} of the individual emitters, a more efficient stack can typically be fabricated with fewer, but wider, emitters.

As described above, the characteristics of a vertically displaced stack of multi-mode, single emitters in accordance with the invention depends upon the characteristics of the individual emitters (i.e., aperture per axis, divergence per axis, output power) as well as the requirements placed on the stack by the device (e.g., fiber) to which the stack's output is to be coupled (i.e., input power, aperture, NA). The inventors have found, however, that certain stack sizes are preferred, based on emitter width. Table II provides the range of preferred stack sizes for specific emitter widths.

**Table II**

| Emitter Width (microns) | Number of Emitters in a Stack |
|---|---|
| 20 to 50 | 2 to 5 |
| 50 to 150 | 2 to 20 |
| 100 to 250 | 2 to 30 |
| 200 to 400 | 2 to 50 |
| 300 to 600 | 2 to 80 |
| 600 to 1200 | 2 to 150 |

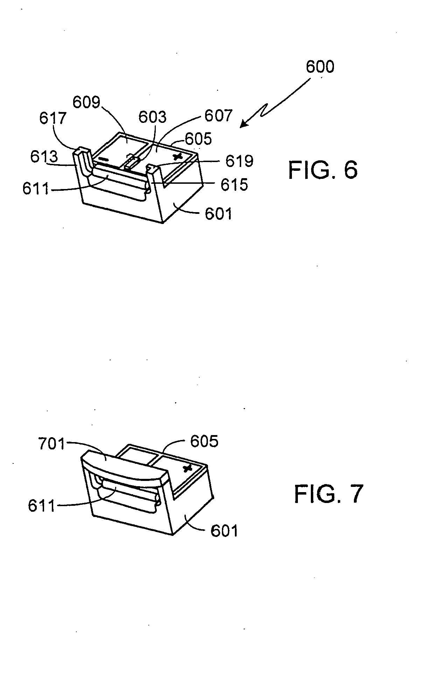

It will be appreciated that the invention is not limited to a particular configuration and is only limited by the requirement that at least two multi-mode, single emitter laser diodes are stacked together such that the output beams from the stack are vertically displaced from one another. Regardless of the design, preferably the stacking assembly that is used is versatile. Figs. 6-12 illustrate one exemplary configuration of a suitable stacking assembly. Additional details regarding this design are provided in co-pending U.S. Patent Application Serial Nos. 11/313,068, filed December 20, 2005; 11/378,570, filed March 17, 2006; 11/378,667, filed March 17, 2006; 11/378,696, filed March 17, 2006; and 11/378,697, filed March 17, 2006; the disclosures of which are incorporated herein by reference for any and all purposes.

In the exemplary configuration illustrated in Figs. 6-12, the laser diode stack is comprised of at least two laser diode subassemblies 600, each subassembly including a submount 601 onto which the laser diode 603 is mounted. As previously noted, laser diode 601 is a multi-mode, single emitter laser diode.. Depending upon the electrical conductivity of submount 601 as well as the desired method of electrically connecting to the laser diodes (e.g., parallel connections, serial connections, individually addressable connections), a laser diode mounting substrate 605 can be interposed between submount 601 and laser diode 603, substrate 605 attached to submount 601 with solder, adhesive, or other means. Regardless of whether or not a laser diode mounting substrate 605 is used, preferably submount 601 is fabricated from a material with a high coefficient of thermal conductivity (e.g., copper). If a laser diode mounting substrate 605 is used, preferably it as well as the means used to attach it to submount 601 are also fabricated from a material with a high coefficient of thermal conductivity. Additionally the coefficient of thermal expansion for the material selected for submount 601 if laser diode 603 is attached directly to the submount, or for laser diode mounting substrate 605 if laser diode 603 is attached to the mounting substrate, is matched to the degree possible to laser diode 603 in order to prevent de-bonding or damage to the laser during operation. In the illustrated embodiment, electrically conductive contact pads 607/609 are deposited or otherwise formed on the top surface of laser diode mounting substrate 605, pads 607/609 used to electrically connect to laser diode 603.

In the illustrated embodiment, a first conditioning lens 611, preferably a cylindrical lens, is positioned relative to laser diode 603 using the extended arm portions 613 and 615 of mounting block 601. Typically lens 611 is located immediately adjacent to the exit facet of laser diode 603. Once lens 611 is properly positioned, it is bonded into place. The purpose of conditioning lens 611 is to reduce the divergence of laser diode 603 in the fast axis, preferably to a value that is the same as or less than the divergence in the slow axis.

In order to condition the output beam of laser diode 603, preferably a second conditioning lens 701 is used. Second conditioning lens 701, although mounted to the top surfaces 617 and 619 of respective arm portions 613 and 615, is not used to condition the beam from the laser diode 603 attached to the same submount. Rather conditioning lens 701 is used to condition the output beam from either an immediately adjacent laser diode subassembly or the output beam from a laser diode subassembly that is more than one subassembly removed.

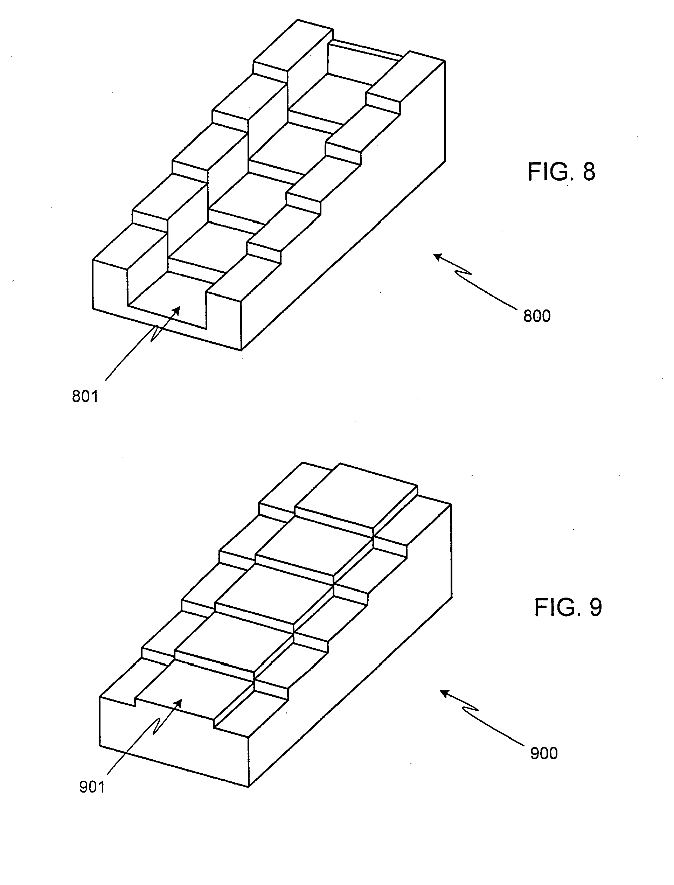

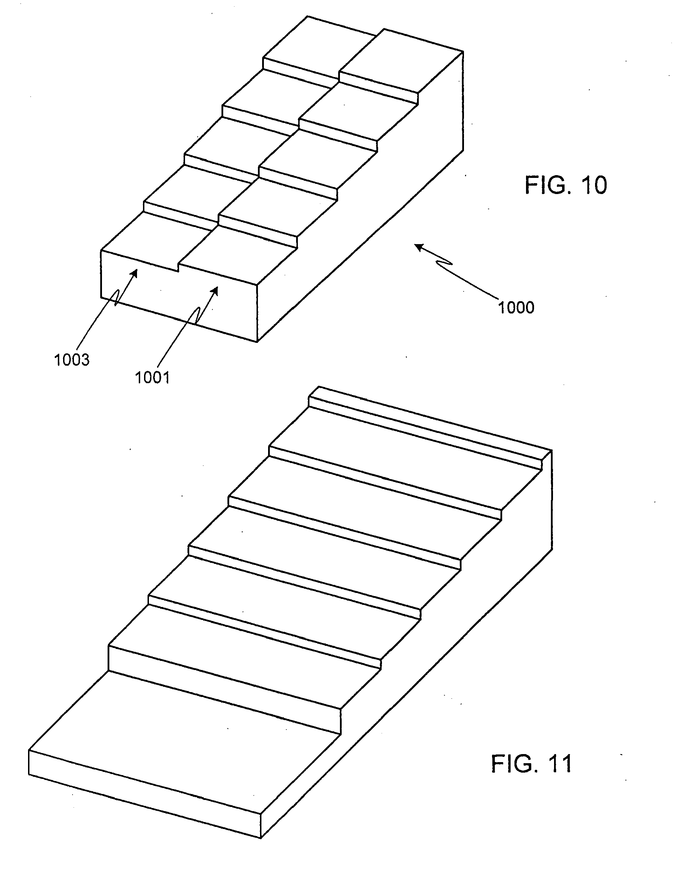

The present invention preferably includes means for mounting at least two laser diode subassemblies into a single laser diode assembly such that the outputs from the individual laser diode subassemblies are vertically displaced relative to one another. For example, laser diode subassemblies such as those shown in Figs. 6-7 are preferably mounted to a stepped cooling block. Exemplary stepped cooling blocks are shown in Figs. 8-11. In addition to providing an efficient thermal path for removing heat from the individual subassemblies, the steps of the cooling block vertically displace the output beams from the laser diode subassemblies. In cooling block 800, the subassemblies are mounted to the central, recessed region 801. In alternate cooling block 900, the subassemblies are mounted to the central, raised region 901. In alternate cooling block 1000, two adjacent sections 1001 and 1003 are provided, with one of the sections (i.e., section 1001) raised relative to the other section (i.e., section 1003). Both the mounting surfaces of upper section 1001 and the mounting surfaces of lower section 1003 are stepped with adjacent mounting surfaces of the two sections being non-coplanar. The laser diode subassemblies can be mounted to either upper section 1001 or lower section 1003, either section providing a plurality of the desired stair-stepped mounting surfaces which allow the subassemblies to be vertically offset from one another. Fig. 11 illustrates yet another alternate cooling block design. Furthermore and as previously noted, in addition to including vertically displaced subassemblies, the cooling block can be designed to include side-by-side subassemblies. It should also be understood that multiple laser diode assemblies, each including one or more laser diode subassemblies, can be combined using simple optical systems in order to obtain the desired performance.

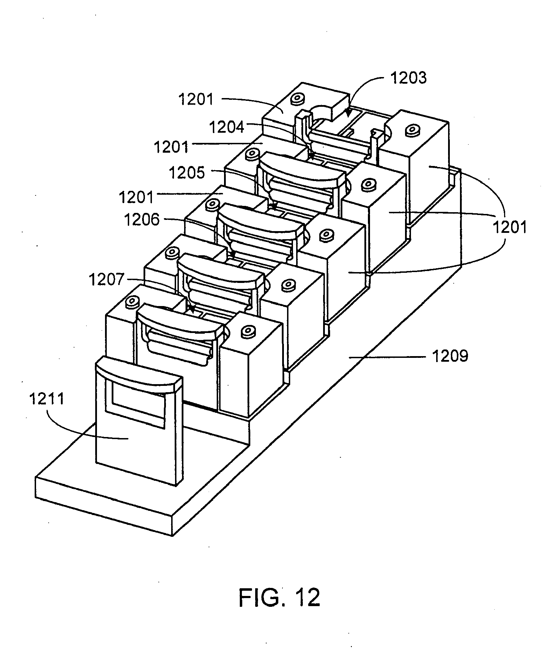

It will be appreciated that the previously described laser diode subassemblies can be mounted to any desired cooling block, such as the previously described cooling blocks, using any of a variety of mounting techniques. Suitable mounting techniques include various arrangements of clamping members, bolts and/or bonding materials (e.g., solder, adhesive). Fig. 12 simply illustrates an exemplary embodiment in which pairs of clamping members 1201, preferably bolted to the cooling block, hold laser diode subassemblies 1203-1207 in place on cooling block 1209. Clamp members 1201 insure that good thermal contact is made between the subassembly submounts and the cooling block. During use, preferably either the cooling block is thermally coupled to a cooling source (e.g., thermoelectric cooler), or the cooling source is integrated within the cooling block (e.g., integral liquid coolant conduits within the cooling block that are coupled to a suitable coolant pump).

In the embodiment illustrated in Fig. 12, the second conditioning lens for each subassembly is located on the arm portions of the adjacent subassembly mounting block. It will be appreciated that the uppermost subassembly, i.e., subassembly 1203, does not include a second conditioning lens and that the second conditioning lens for the lowermost subassembly, i.e., subassembly 1207, is simply mounted to a stand alone lens carrier 1211. Carrier 1211 can either be integral to cooling block 1209, i.e., machined from the same material, or it can be an independent carrier that is mounted to cooling block 1209.

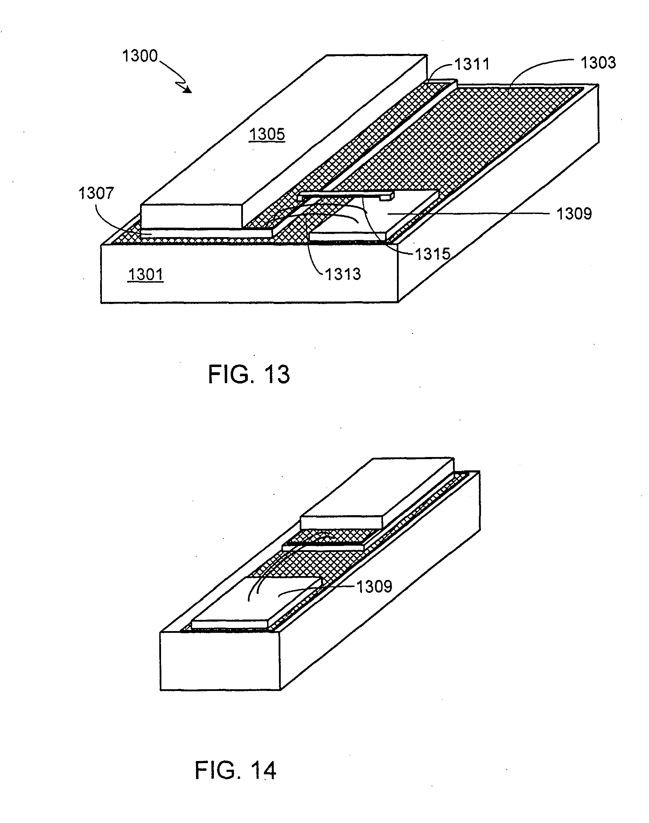

A second exemplary design for the individual laser diode subassemblies and the laser diode stack is shown in Figs. 13-18. Additional details regarding this design are provided in co-pending U.S. Patent Application Serial Nos. 11/384,940, filed March 20, 2006; 11/417,581, filed May 4, 2006; and 11/492,140 , filed July 24, 2006, the disclosures of which are incorporated herein by reference in their entirety for any and all purposes.

Fig. 13 is an illustration of an individual laser diode subassembly 1300 which, similar to the previous exemplary embodiment, is versatile and can be used in a variety of assembly configurations. To achieve the desired levels of performance and reliability, preferably submount 1301 is comprised of a material with a high thermal conductivity and a CTE that is matched to that of the laser diode. Preferably on the upper surface of submount 1301 is a layer 1303 of a bonding solder. On top of submount 1301 is a spacer that is preferably comprised of a first contact pad 1305 and an electrically insulating isolator 1307 interposed between contact pad 1305 and submount 1301. Preferably insulating isolator 1307 is attached to submount 1301 via solder layer 1303. Preferably contact pad 1305 is attached to isolator 1307 using the same solder material as that of layer 1303. Also mounted to submount 1301 via solder layer 1303 is a multi-mode, single emitter laser diode 1309. In the illustrated embodiment, one contact of laser diode 1309 is made via submount 1301, while the second contact is made using wire bonds, ribbon bonds, or other electrical connector which couple the laser diode to metallization layer 1311. For illustration purposes, both representative wire bonds 1313 and a representative contacting member 1315 are shown in Fig. 13, although it will be appreciated that in a typical application only a single type of electrical connector would be used. Additional details regarding the design shown in Fig. 13 are provided in co-pending U.S. Patent Application Serial Nos. 11/384,940, filed March 20, 2006, the disclosure of which is incorporated herein by reference in its entirety for any and all purposes.

It will be appreciated that there are a variety of variations of the subassembly shown in Fig. 13 that can also be used with the invention. For example, instead of mounting the spacer assembly (e.g., insulator 1307 and contact pad 1305) next to the laser diode, this assembly can be mounted to the rear of the laser diode as illustrated in Fig. 14. In addition to its compact design, this configuration insures efficient lateral dissipation of heat from laser diode 1309. Additional details regarding the design shown in Fig. 14 are provided in co-pending U.S. Patent Application Serial Nos. 11/417,581, filed May 4, 2006, the disclosure of which is incorporated herein by reference in its entirety for any and all purposes.

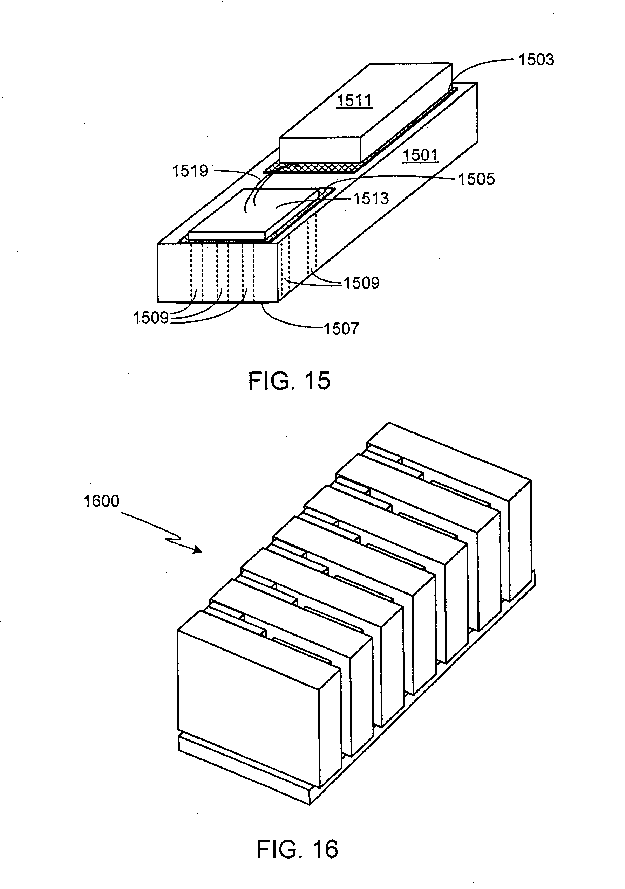

Additionally it will be appreciated that the subassembly shown in Figs. 13 and 14 can utilize alternate contacting arrangements. For example, Fig. 15 illustrates an alternate configuration similar to that shown in Fig. 14 utilizing an electrically non-conductive submount 1501. Electrically conductive bonding layers 1503 and 1505 are deposited on the upper surface of submount 1501 while an electrically conductive bonding layer 1507 is deposited on the lower surface of submount 1501. Submount 1501 includes at least one via 1509, and preferably multiple vias 1509, that provide an electrically conductive path between metallization layer 1505 and metallization layer 1507. Vias 1509 can utilize copper or any of a variety of conductive materials. A conductive spacer 1511 is mounted on top of, and in electrical contact with, metallization layer 1503. Spacer 1511 serves as a contact pad, preferably the N contact, for laser 1513. Laser diode 1513 is electrically coupled to conductive spacer 1511 using wire bonds 1519 or other electrical connector means (e.g., ribbon bonds or other connecting members) which couple the laser diode to metallization layer 1503. The second contact of laser diode 1513, preferably the P contact, is made via metallization layer 1507 which, as previously described, is electrically coupled to metallization layer 1505 on which laser diode 1513 resides. Design details as well as design variations of the configuration shown in Fig. 15 are provided in co-pending U.S. Patent Application Serial Nos. 11/492,140, filed July 24, 2006, the disclosure of which is incorporated herein by reference in its entirety for any and all purposes.

After completion of a subassembly such as one of those shown in Figs. 13-15, and after completing any desired subassembly testing, stacks of subassemblies are formed. Figs. 16 and 17 illustrate two laser diode stacks, stack 1600 utilizing side-by-side subassemblies such as that shown in Fig. 13 and stack 1700 utilizing front-to-back subassemblies such as that shown in Fig. 15. As previously noted, the invention only requires a stack of at least two subassemblies. As with the previous exemplary configuration, it should be understood that any of a variety of optical systems can be used to combine the outputs from the individual laser diode subassemblies in order to obtain the desired performance.

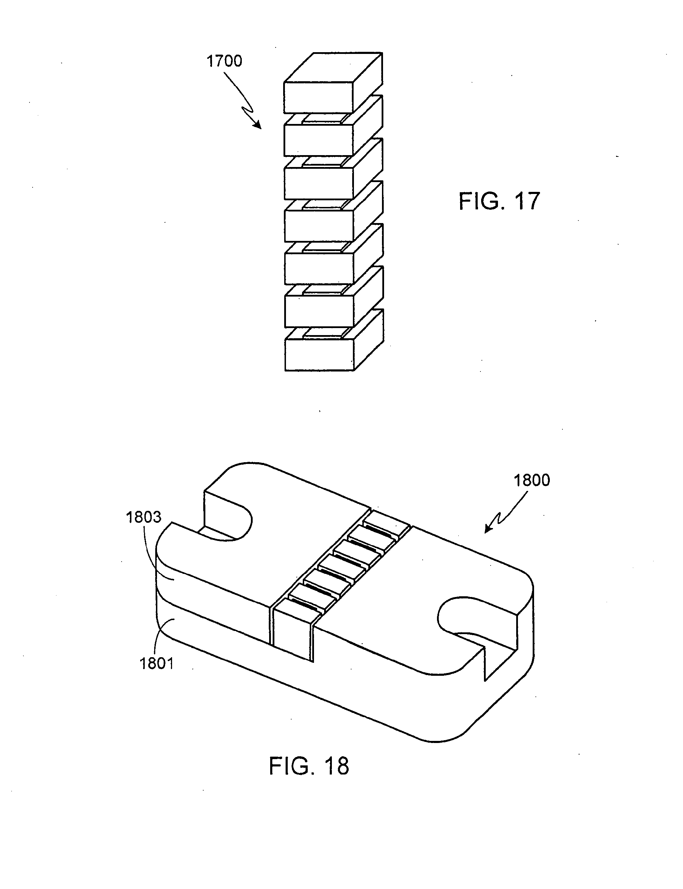

Depending upon how the laser diodes of the individual subassemblies are electrically contacted/connected as well as the materials used, the stack can either be mounted directly to a thermal cooling block or backplane and side frame members can be interposed between the stack and the cooling block. In the exemplary embodiment shown in Fig. 18, cooling block 1800 is comprised of a primary member 1801 and a secondary member 1803.

It will be appreciated that the present invention is not limited to the stack assembly configurations shown in Figs. 6-18. As previously described, the invention is the use of at least two laser diode subassemblies, vertically displaced, whether coupled together into a single assembly or not.

As will be understood by those familiar with the art, the present invention may be embodied in other specific forms without departing from the spirit or essential characteristics thereof. Accordingly, the disclosures and descriptions herein are intended to be illustrative, but not limiting, of the scope of the invention which is set forth in the following claims.

## Claims

1. An optical source comprising:
a stack comprised of a plurality of laser diode subassemblies, each of said plurality of laser diode subassemblies comprising:
a submount; and
a multi-mode, single emitter laser diode attached to a first surface of said submount; and
a mounting member, wherein each of said plurality of laser diode subassemblies is mounted to said mounting member to form said stack; and
means for vertically displacing a plurality of output beams corresponding to said plurality of laser diode subassemblies.

2. The optical source of claim 1, wherein each of said multi-mode, single emitter laser diodes has an emitter width in the range of 20 microns to 50 microns, and wherein said plurality of laser diode subassemblies is comprised of 2 to 5 laser diode subassemblies.

3. The optical source of claim 1, wherein each of said multi-mode, single emitter laser diodes has an emitter width in the range of 50 microns to 150 microns, and wherein said plurality of laser diode subassemblies is comprised of 2 to 20 laser diode subassemblies.

4. The optical source of claim 1, wherein each of said multi-mode, single emitter laser diodes has an emitter width in the range of 100 microns to 250 microns, and wherein said plurality of laser diode subassemblies is comprised of 2 to 30 laser diode subassemblies.

5. The optical source of claim 1, wherein each of said multi-mode, single emitter laser diodes has an emitter width in the range of 200 microns to 400 microns, and wherein said plurality of laser diode subassemblies is comprised of 2 to 50 laser diode subassemblies.

6. The optical source of claim 1, wherein each of said multi-mode, single emitter laser diodes has an emitter width in the range of 300 microns to 600 microns, and wherein said plurality of laser diode subassemblies is comprised of 2 to 80 laser diode subassemblies.

7. The optical source of claim 1, wherein each of said multi-mode, single emitter laser diodes has an emitter width in the range of 600 microns to 1200 microns, and wherein said plurality of laser diode subassemblies is comprised of 2 to 150 laser diode subassemblies.

8. The optical source of claim 1, wherein a single member comprises both said vertically displacing means and said mounting member.

9. The optical source of claim 8, wherein said single member is comprised of a plurality of stepped mounting surfaces, wherein said at least two laser diode subassemblies are mounted to different mounting surfaces of said plurality of stepped mounting surfaces.

10. The optical source of claim 1, wherein said mounting member comprises a cooling block.
